# EUROPÄISCHE PATENTANMELDUNG

(11) **EP 3 557 275 A1**
(43) Veröffentlichungstag der Anmeldung: **23.10.2019**
(21) Anmeldenummer: 18167504.2
(22) Anmeldetag: 16.04.2018
(51) Int. Cl.: G01R 33/563, G01R 33/561, G01R 33/565

(54) **DIFFUSIONSGEWICHTETE MAGNETRESONANZBILDGEBUNG MIT FLUSSKOMPENSIERTEN MAGNETFELDGRADIENTEN**

(71) Anmelder: Siemens Healthcare GmbH, 91052 Erlangen (DE)
(72) Erfinder: Feiweier, Thorsten, 91099 Poxdorf (DE)

(57) **Zusammenfassung**

Verfahren zur Aufnahme von Magnetresonanzdaten mit einer Magnetresonanzeinrichtung, wobei zur Einzelschussaufnahme der Magnetresonanzdaten eine mehrfach refokussierte Spinechosequenz verwendet wird, in der in einem Präparationsmodul (14, 18) anschließend an einen Anregungspuls (1) wenigstens zwei Präparationsgradientenpulse (15, 16) und wenigstens ein Refokussierungspuls (4) ausgegeben werden und an das Präparationsmodul (14, 18) anschließend in einem Aufnahmemodul (3) mehrere Folgen eines Refokussierungspulses (5) und eines Auslesezeitraums (6) verwendet werden, wobei in ihrer Gesamtheit flusskompensierte Präparationsgradientenpulse (15, 16) verwendet werden.

## Beschreibung

Die Erfindung betrifft ein Verfahren zur Aufnahme von Magnetresonanzdaten mit einer Magnetresonanzeinrichtung, insbesondere zur Diffusionsbildgebung, wobei zur Einzelschussaufnahme der Magnetresonanzdaten eine mehrfach refokussierte Spinechosequenz verwendet wird, in der in einem Präparationsmodul anschließend an einen Anregungspuls wenigstens zwei Präparationsgradientenpulse und wenigstens ein Refokussierungspuls ausgegeben werden und an das Präparationsmodul anschließend in einem Aufnahmemodul mehrere Folgen eines Refokussierungspulses und eines Auslesezeitraums verwendet werden. Daneben betrifft die Erfindung eine Magnetresonanzeinrichtung, ein Computerprogramm und einen elektronisch lesbaren Datenträger.

Bei der Magnetresonanzbildgebung, insbesondere im klinischen Einsatz, wurden bereits Aufnahmetechniken vorgeschlagen, in denen in Präparationsmodulen der entsprechenden Magnetresonanzsequenz Präparationsgradienten genutzt werden, um bestimmte Aspekte innerhalb des Aufnahmebereichs abbilden zu können. Insbesondere ist die sogenannte Diffusionsbildgebung bzw. diffusionsgewichtete Bildgebung aus der heutigen, klinischen Praxis kaum noch wegzudenken, was die Klärung neurologischer oder onkologischer Fragestellungen angeht. Mit der Diffusionsbildgebung werden Magnetresonanzdaten aufgenommen, die die ungerichtete Diffusion an den verschiedenen Bildelementen des entstehenden Magnetresonanzdatensatzes beschreiben soll.

Zur diffusionsgewichteten Bildgebung (Diffusionsbildgebung) wurden verschiedene Ansätze vorgeschlagen, um diese konkret umzusetzen. Zunächst ist es im Stand der Technik bekannt, den k-Raum mit mehrfach refokussierten Gradientenechos als echoplanaren "Schnappschuss" ("single-shot echoplanar imaging", ss-EPI) oder in segmentierter Abtastung ("multi-shot echoplanar imaging", ms-EPI, beispielsweise die RESOLVE-Sequenz) aufzunehmen, nachdem diese Vorgehensweisen sehr effizient sind, ein hohes Signal-zu-Rauschverhältnis liefern und bei der Abtastung des k-Raums nur ein Echopfad relevant ist, da während der Magnetresonanzdatenaufnahme keine weiteren Refokussierungspulse angewendet werden, so dass unerwünschte Interferenzartefakte ausbleiben.

Allerdings haben diese gradientenecho-basierten Bildgebungstechniken auch Nachteile, insbesondere die Kumulation von Phasenabweichungen während der Abtastung des k-Raums, was zu geringen Pixelbandbreiten, beispielsweise von nur wenigen 10 Hz pro Pixel, entlang der Phasenkodierungsrichtung führt. Daraus folgt eine hohe Empfindlichkeit auf unvermeidliche räumliche Variationen des Grundmagnetfeldes der Magnetresonanzeinrichtung (B0-Feld), beispielsweise auf Grund von Änderungen der Suszeptibilität bei Übergängen zwischen unterschiedlichen Gewebearten eines Patienten (beispielsweise von Knochen zu Weichteilgewebe) oder zur umgebenden oder eingeschlossenen Luft (beispielsweise bei Aufnahmen, die die Nebenhöhlen und/oder die Lunge umfassen). In auf Grund der Magnetresonanzdaten erzeugten Magnetresonanzbildern manifestieren sich diese Effekte in Form von Artefakten, die lokale Verzerrungen und lokale Variationen der Signalintensität ("signal pile-up") umfassen können. Etablierte Korrekturverfahren, beispielsweise Justage des Grundmagnetfeldes (shimming), schichtspezifische Justagen und/oder Bildkorrekturverfahren, lassen sich diese Bildartefakte, insbesondere bei sehr lokaler Ausprägung, nur eingeschränkt reduzieren.

Es existieren klinische Fragestellungen, bei denen diese lokalen Bildartefakte, insbesondere Regionen mit lokalen Signal-Hyperintensitäten, leicht mit gesuchten Läsionen verwechselt werden können. Dies gilt beispielsweise für die Diagnose eines Cholesteatoms im Innenohr. Sowohl ss-EPI- als auch ms-EPI-Verfahren zur Diffusionsbildgebung erweisen sich hier, insbesondere bei Feldstärken von 1,5 T oder mehr, als ungeeignet.

Daher wurde im Stand der Technik vorgeschlagen, Aufnahmetechniken mit mehrfach refokussierten Spinechos zu verwenden. Dabei können sowohl sogenannte "Schnappschuss"-Techniken (beispielsweise HASTE-Diffusions-Technik) und segmentierte Techniken (beispielsweise BLADE-Diffusions-Technik) zum Einsatz kommen. Durch die Refokussierungspulse während des Aufnahmemoduls der Spinechosequenz wird die Akkumulation von Phasenfehlern vermieden, so dass grundsätzlich hinreichend homogene Bilder mit geringen Verzerrungen erzeugt werden können. Die bei Spinechotechniken gegebene, etwas geringere Messeffizienz (auf Grund der benötigten zusätzlichen Hochfrequenzpulse und gegebenenfalls SAR-Limitierungen) kann im klinischen Alltag in Kauf genommen werden.

Allerdings existieren bei derartigen Spinechotechniken ebenso Nachteile, insbesondere die durch die Vielzahl von Hochfrequenzpulsen, insbesondere die Refokussierungspulse, erzeugten zusätzlichen Signalkohärenzpfade (beispielsweise sogenannte stimulierte Echos). Diese unerwünschten, zusätzlichen Signalkohärenzpfade können ohne weitere Maßnahmen zu Interferenzartefakten führen, die die Bildinterpretation, insbesondere bei höheren Feldstärken, erschweren oder verhindern.

Die Ursache derartiger Interferenzartefakte sind, wie bereits erwähnt, unerwünschte Signalkohärenzpfade, die bei einer Spinechomessung unter perfekten Umgebungsbedingungen nicht auftreten würden, da die vorgesehenen Flipwinkel an jedem Ort innerhalb einer angeregten Schicht exakt vorlägen. Das bedeutet, in einer solchen perfekten Umgebung würde einer der vielen verwendeten Refokussierungspulse überall zu einem Flipwinkel von exakt 180° führen, so dass nur genau ein relevanter Signalkohärenzpfad, also ein relevantes Spinecho, vorliegt und keine zusätzlichen "stimulierten Echos" auftreten, so dass die aufgenommenen Bilder frei von Artefakten wären. Dies gälte unabhängig von der relativen Phasenlage zwischen der angeregten Magnetisierung (nach dem Präparationsmodul) und dem B1-Feld der Refokussierungspulse.

In der Praxis treten jedoch Effekte auf, die zu (lokalen) Abweichungen vom idealen Flipwinkel führen:
a) Räumliche Variation des von der sendenden Hochfrequenzspulenanordnung generierten B1-Feldes auf Grund der Spulengeometrie,
b) Räumliche Variation des von der sendenden Hochfrequenzspulenanordnung erzeugten B1-Feldes auf Grund der Interaktion mit dem Gewebe (Leitfähigkeit, Dielektrizität), insbesondere bei höheren Feldstärken (1,5 T oder höher), und
c) Räumliche Variation entlang der Schichtnormalen (Abweichungen vom perfekt rechteckigen Schichtprofil).

Um Interferenzartefakte zu vermeiden, ist es bei der Spinechobildgebung bekannt, eine CPMG-Pulsfolge zu verwenden. Dabei wird zunächst ein Hochfrequenz-Anregungspuls mit einem B1-Feld entlang beispielsweise der x-Achse eines rotierenden Koordinatensystems ausgegeben, der eine Transversalmagnetisierung entlang der y-Achse (wiederum in rotierenden Koordinaten) erzeugt. Die folgenden Hochfrequenz-Refokussierungspulse, wobei der erste in einem Abstand T/2, alle weiteren im Abstand T ausgegeben wird, werden mit einem B1-Feld entlang der rotierenden y-Achse (im Beispiel) appliziert. Auf diese Weise wird der Einfluss stimulierter Signalkohärenzpfade unterdrückt und es können artefaktfreie Magnetresonanzbilder aus den Magnetresonanzdaten ermittelt werden.

In Kombination mit einem Präparationsgradientenpuls, insbesondere also bei einer diffusionsgewichteten Präparation ist dieser Ansatz nicht mehr möglich. Dies liegt darin begründet, dass bereits geringfügige (kohärente) Bewegungen im Aufnahmegebiet zu einer Änderung der Phasenlage des zu refokussierenden Magnetresonanzsignals führen, so dass es nicht länger möglich ist, an jedem Ort im Aufnahmebereich die CPMG-Phasenbedingungen zu erfüllen. In der Konsequenz kommt es wiederum zu unerwünschten Interferenzartefakten, die umso stärker ausgeprägt sind, je weiter der lokale Refokussierungs-Flipwinkel vom Idealwert abweicht. Anders gesagt liegt das Problem also darin, dass unterschiedliche (kohärente) Bewegungen zu unterschiedlichen Phasenverschiebungen der Transversalmagnetisierung führen. Bereits geringe Abweichungen von den vorgesehenen Flipwinkeln können zu den Interferenzartefakten führen, die durch die Existenz unterschiedlicher Signalkohärenzpfade auftreten. Dabei sollen im Folgenden die unerwünschten Signalkohärenzpfade, welche mithin die CPMG-Phasenbedingungen nicht erfüllt, als Nicht-MG-Signalanteile bezeichnet werden, während die die CPMG-Phasenbedingungen wie gewünscht erfüllenden Signalanteile als MG-Signalanteile bezeichnet werden sollen.

Im Stand der Technik sind nun im Wesentlichen drei Vorgehensweisen bekannt, um die insbesondere durch Bewegung auftretenden Nicht-MG-Signalanteile zu behandeln.

In einer ersten Vorgehensweise können die unerwünschten Nicht-MG-Signalbeiträge unterdrückt werden. Hierbei werden zusätzliche Gradienten- und Hochfrequenzpulse nach dem Präparationsmodul geschaltet, um alle Signalbeiträge, die nicht der CPMG-Phase entsprechen, im Beispiel also die Signalanteile, die nicht entlang der rotierenden y-Achse zeigen, eliminiert werden. Nachteilhafterweise tritt dabei jedoch ein Signalverlust von 50 % auf, so dass die vierfache Anzahl an Mittelungen notwendig ist, um das ursprüngliche Signal-zu-Rausch-Verhältnis wieder herzustellen. Rein beispielhaft sei diesbezüglich auf US 6,489,766 B1 verwiesen.

Ein zweiter Ansatz sieht vor, die MG-Signalanteile und die Nicht-MG-Signalbeiträge getrennt aufzunehmen. Dabei werden zusätzliche Gradientenpulse und längere Aufnahmeintervalle eingesetzt, um separate, jeweils artefaktfreie Magnetresonanzdaten der beiden Signalbeiträge aufnehmen zu können. Nachteilhafterweise werden dabei jedoch deutlich längere Echozüge verwendet, das heißt, es treten Bildunschärfe und Signalverlust durch den T2-Zerfall auf.

Schließlich wurde vorgeschlagen, die Bildgebung lediglich bei geringeren Feldstärken, insbesondere 1,5 T oder weniger, durchzuführen, so dass B1-Variationen durch Gewebeinteraktion eine kleinere Rolle spielen. Allerdings können bestimmte Diagnosen auf Geräten mit höherer Feldstärke dann nicht durchgeführt werden.

Der Erfindung liegt daher die Aufgabe zu Grunde, Bildartefakte bei der diffusionsgewichteten Bildgebung mit mehrfach refokussierten Spinechos anzugeben, welche insbesondere ohne die Notwendigkeit zur Unterdrückung oder Trennung interferierender Signalkohärenzpfade auskommt und auch bei höheren Feldstärken einsetzbar ist.

Zur Lösung dieser Aufgabe ist bei einem Verfahren der eingangs genannten Art erfindungsgemäß vorgesehen, dass in ihrer Gesamtheit flusskompensierte Präparationsgradientenpulse verwendet werden.

Flusskompensiert ist dabei im Rahmen der vorliegenden Erfindung so zu verstehen, dass nicht nur das nullte Moment der Gesamtheit der Präparationsgradientenpulse, insbesondere also der Diffusionsgradientenpulse, zumindest im Wesentlichen Null beträgt, sondern auch wenigstens das erste Moment der Gesamtheit der Präparationsgradientenpulse zumindest im Wesentlichen Null beträgt, bevorzugt auch höhere Momente möglichst gering gewählt werden. Dabei ist selbstverständlich die Wirkungsrichtung relativ zu den Spins zu berücksichtigen, das bedeutet, das erste Moment ist als das Zeitintegral über die Zeit multipliziert mit den Gradientenamplituden unter Berücksichtigung der Wirkungsrichtung zu verstehen. Wird beispielsweise nach einem Gradientenpuls ein Refokussierungspuls mit einem 180°-Flipwinkel eingesetzt, ist die Wirkung des Präparationsgradienten umgekehrt, was einer Vorzeichenumkehr entspricht.

Die Erfindung beruht dabei auf Erkenntnissen zur Entstehung der MG- und Nicht-MG-Signalbeiträge durch das Präparationsmodul. In dem Präparationsmodul, insbesondere also bei der Diffusionspräparation, wird die räumliche Lage der untersuchten Moleküle, beispielsweise Wasser, der zugehörigen Transversalmagnetisierung zunächst mit Hilfe von Kodierungs-Gradientenpulsen in Form einer Phase aufgeprägt. Danach werden die Lageänderungen mit Dekodierungs-Gradientenpulsen detektiert. Sofern sich die Position der Moleküle entlang der Richtung der Kodierung (also der Richtung der Diffusionsgradienten) über diesen Beobachtungszeitraum nicht ändert, erfolgt eine Rephasierung des Magnetresonanzsignals entlang einer definierten Richtung. Mikroskopische oder makroskopische Lageänderungen führen zu einer Änderung der Magnetresonanzsignalphase. Die spezielle Eigenschaft der Diffusion ist es nun, eine inkohärente Bewegung darzustellen, mithin stochastische Lageveränderungen aufzuweisen. Solche stochastischen Lageänderungen führen zu einer Verteilung der Magnetresonanzsignalphasen innerhalb eines Bildelements und somit zu einer vom Ausmaß der Lageveränderung (Diffusionskoeffizient) abhängigen Reduzierung der integralen Amplitude des Magnetresonanzsignals. Durch Variation der Stärke und Richtung der Diffusionskodierung können so beispielsweise Diffusionsparameter, beispielsweise Trace-Karten, ADC-Karten ("apparent diffusion coefficient") und dergleichen bestimmt werden.

Für das erfindungsgemäße Vorgehen ist entscheidend, dass stochastische Lageveränderungen mit gleicher Wahrscheinlichkeit in Richtung und in Gegenrichtung der Diffusionskodierungsrichtung erfolgen. Damit existiert zu jeder "positiven" Änderung der Signalphase einiger Spins eine entsprechende "negative" Änderung für andere Spins. In der Summe bedeutet dies, dass stochastische Lageveränderungen nicht zu einer Veränderung der Phase des integralen Magnetresonanzsignals beitragen und somit nicht zum Aufbau einer Nicht-MG-Komponente führen.

Neben stochastischen, inkohärenten Lageveränderungen, auf die die Diffusionsmessung abzielt, finden allerdings auch gerichtete, also kohärente, Lageveränderungen statt, bei denen sich zumindest ein Teil der signalgebenden Spins in gleicher Weise entlang der Diffusionskodierungsrichtung bewegt. Solche kohärenten Bewegungen umfassen Pulsation und Fluss, aber auch makroskopische Patientenbewegungen, insbesondere die Atmung. Hinsichtlich des Einflusses auf die Magnetresonanzsignalphase bei der Diffusionskodierung unterscheiden sich gerichtete Bewegungen von ungerichteten Bewegungen dadurch, dass sich bei der gerichteten Bewegung innerhalb eines Bildelements, insbesondere Voxels, eine bestimmte Magnetresonanzsignalphase aufbaut (also keine Gleichverteilung in beide Richtungen) und es keine "kompensierende" Gegenbewegung gibt. Kohärente Lageveränderungen führen somit zu einer von der Richtung und Ausprägung der kohärenten Bewegung abhängigen Änderung der integralen Magnetresonanzsignalphase, was eine Ursache für die Entstehung einer ortsabhängigen Nicht-MG-Komponente und somit für das Auftreten von Interferenzartefakten ist, da die CPMG-Phasenbedingung nicht mehr erfüllt ist.

Die Bildqualität lässt sich also verbessern, wenn man den Einfluss kohärenter Lageveränderungen auf die Phase des Magnetresonanzsignals reduzieren könnte. Dies gelingt gemäß der vorliegenden Erfindung durch die Verwendung einer Präparationsgradientenabfolge G(t), für die das erste Moment M1 = *∫*dt G(t) t verschwindet. Mit besonderem Vorteil werden dabei auch höhere Momente, beispielsweise das zweite und/oder dritte Moment möglichst klein gewählt, das bedeutet, es kann vorgesehen sein, dass die Präparationsgradientenpulse zudem wenigstens ein höheres Moment minimierend gewählt werden. Dies entspricht letztlich dem im Magnetresonanz-Umfeld bekannten Prinzip der "Flusskompensation".

Dabei kann in einer beispielhaften Ausgestaltung vorgesehen sein, dass zwei jeweils vor und nach einem Refokussierungspuls des Präparationsmoduls auszugebende Präparationsgradientenpulse verwendet werden, wobei insbesondere jeder der Präparationsgradientenpulse zwei Teilpulse gleicher Dauer und Amplitude, aber umgekehrten Vorzeichens aufweist.

Hierbei können selbstverständlich Anpassungen vorgenommen werden, insbesondere in Dauer und Amplitude der Teilpulse, wobei darauf zu achten ist, dass das erste Moment weiterhin zumindest im Wesentlichen Null beträgt.

Zusammenfassend kann mithin gesagt werden, dass durch die Nutzung flusskompensierter Präparationsgradientenpulse Gradientenverteilungen so vorliegen, dass die entstehenden integralen Magnetresonanzsignalphasen auf Grund der kohärenten Bewegung sich gegenseitig ausgleichen und insbesondere möglichst weitgehend aufheben. Die CPMG-Phasenbedingung ist somit wieder erfüllt und die CPMG-Pulsfolge kann wie üblich verwendet werden, um Interferenzartefakte zu vermeiden/zu reduzieren.

Es wird darauf hingewiesen, dass flusskompensierte Diffusionsgradienten für einen anderen Zweck im Stand der Technik bereits bei mehrfach refokussierten Gradientenechosequenzen vorgeschlagen wurden. Dabei wird ein Vergleich von flusskompensierten und nicht-flusskompensierten Diffusionsbildern durchgeführt, um eine genauere Analyse des Perfusionsanteils bei IVIM-Verfahren zu ermöglichen, wozu rein beispielhaft auf die Artikel von Wetscherek et al., Magnetic Resonance in Medicine 74 (2015) 410, und Ahlgren et al., Nuclear Magnetic Resonance in Biomedicine 29 (2016) 640, verwiesen. Vorliegend wird die Verwendung von flusskompensierten Diffusionsgradienten bei mehrfach refokussierten Spinechosequenzen, insbesondere der Schnappschuss-Bildgebung mit HASTE-Auslesezug, zum Zwecke der Unterdrückung von Interferenzartefakten vorgeschlagen.

Schließlich sei noch angemerkt, dass die vollständige Flusskompensation, mithin ein exakt Null entsprechendes erstes Moment sowie möglichst niedrige, insbesondere auch Null entsprechende höhere Momente die erstrebenswerte beste Lösung darstellen, jedoch andere Randbedingungen beachtet werden müssen (beispielsweise maximale Gradientenamplituden, der Dutycycle der Hardware und dergleichen), die geringe Abweichungen von diesen Optimalwerten bedingen können. Nichtsdestotrotz ist auch dann bereits eine Verbesserung gegeben.

Erste Testmessungen bei 3 T haben gezeigt, dass eine deutliche Reduktion von Interferenzartefakten durch die Verwendung flusskompensierter Diffusionsgradienten möglich ist. Insbesondere sei darauf hingewiesen, dass das hier vorgestellte Verfahren bevorzugt bei Grundmagnetfeldstärken von wenigstens 1,5 T, insbesondere wenigstens 3 T, eingesetzt wird.

In einer vorteilhaften Weiterbildung der vorliegenden Erfindung kann vorgesehen sein, dass als Spinechosequenz eine HASTE-Sequenz verwendet wird. Das Akronym HASTE steht dabei für Half-fourier Acqusition Single-shot Turbo spin Echo, wobei entsprechende Sequenzen auch als SS-FSE, SSH-TSE, UFSE und FASE bekannt sind.

Eine besonders bevorzugte Weiterbildung der vorliegenden Erfindung sieht vor, dass in dem Präparationsmodul zwei adiabatische, insbesondere identische Refokussierungspulse verwendet werden, die zeitlich jeweils zwischen Präparationsgradientenpulsen liegen. Eine flusskompensierte Diffusionskodierung in dem Präparationsmodul lässt sich auch mit zwei Refokussierungspulsen realisieren. Dabei können mit besonderem Vorteil zwei adiabatische Refokussierungspulse, insbesondere hyperbolische Secantpulse oder FOCI-Pulse (Frequency Offset Corrected Inversion), verwendet werden, die ein aufeinander abgestimmtes, sich wechselseitig kompensierendes Phasenprofil aufweisen. Durch adiabatische Refokussierungspulse kann eine bessere Einstellung des Wunsch-Flipwinkels, hier 180 °, erreicht werden, so dass Bildinhomogenitäten auf Grund von räumlichen B1-Variationen reduziert werden. Mit besonderem Vorteil können dabei zwei identische adiabatische Refokussierungspulse eingesetzt werden, so dass sich das Phasenprofil implizit kompensiert. Die Verwendung adiabatischer Refokussierungspulse wäre grundsätzlich auch bei einem einzigen Refokussierungspuls möglich, vgl. Dyvorne et al., Magn. Reson. Med. 75 (106), Seite 1949. Die Bildqualität wird so weiter verbessert.

Dabei sei darauf hingewiesen, dass allgemein auch die Refokussierungspulse des Präparationsmoduls prinzipiell unerwünschte Signalkohärenzpfade generieren können. Während aber jedoch die Verwendung eines einzigen Hochfrequenz-Refokussierungspulses neben der Nutzkohärenz nur zwei FID-Pfade (free induction decay) erzeugt, existieren bei einer doppelt-refokussierten Spinechopräparation, also bei der Verwendung von zwei Refokussierungspulsen, bereits acht unerwünschte Signalkohärenzpfade, nämlich drei FID-Pfade, drei Spinechos und zwei stimulierte Echos. In diesem Kontext kann vorgesehen sein, etablierte Verfahren zur Unterdrückung dieser zusätzlichen, unerwünschten Signalkohärenzpfade einzusetzen.

In einer beispielhaften Ausgestaltung kann vorgesehen sein, dass zur Unterdrückung von insbesondere durch den Anregungspuls und die Refokussierungspulse des Präparationsmoduls erzeugten, unerwünschten Signalkohärenzpfaden gegenüber den erwünschten Signalkohärenzpfaden Dephasierungsgradienten verwendet werden. So wird beispielhaft in der DE 10 2014 206 929 A1 ein Verfahren zur Aufnahme von Magnetresonanzdaten mit einer Bildaufnahmesequenz vorgeschlagen, wobei die Bildaufnahmesequenz ein Präparationsmodul als Zeitabschnitt aufweist, in dem mehrere Präparationsgradienten zur Präparation der Magnetresonanzsignale vor einem Auslesen geschaltet werden. In einem Ausleseabschnitt (Aufnahmemodul) mit Auslesegradienten werden die Magnetresonanzsignale ausgelesen, um Magnetresonanzdaten zu erzeugen. Durch Hochfrequenzpulse der Bildaufnahmesequenz werden Magnetresonanzsignalanteile mit einem erwünschten Signalkohärenzpfad und Magnetresonanzsignalanteile mit einem unerwünschten Signalkohärenzpfad erzeugt, wobei im Ausleseabschnitt überwiegend die Magnetresonanzsignalanteile mit erwünschtem Signalkohärenzpfad aufgenommen werden. Das dortige Verfahren weist die Schritte des Bestimmens der Magnetresonanzsignalanteile der unerwünschten Signalkohärenzpfade für die verwendete Bildaufnahmesequenz und des Schaltens von Dephasierungsgradienten, um die Aufnahme von Magnetresonanzsignalanteilen mit unerwünschten Signalkohärenzpfaden zu verringern, auf, wobei die Dephasierungsgradienten unter Berücksichtigung der verwendeten Präparationsgradienten und unter Berücksichtigung der unerwünschten Signalkohärenzpfade derart bestimmt werden, dass die Magnetresonanzsignalanteile mit unerwünschten Signalkohärenzpfaden verringert werden, indem die Gradientenmomente der Dephasierungsgradienten derart bestimmt werden, dass das Dephasierungsgradientenmoment für jeden unerwünschten Signalkohärenzpfad größer als ein Schwellenwert ist, wobei die Dephasierungsgradienten unabhängig von den Zeitspannen, in denen die Präparationsgradienten geschaltet werden, und nur in Abhängigkeit von der effektiven Größe der Gradientenmomente der Präparationsgradienten bestimmt werden. Das entsprechende Verfahren kann auch im Rahmen der vorliegenden Erfindung ergänzend eingesetzt werden.

In einer weiteren, bevorzugten Ausgestaltung der vorliegenden Erfindung kann vorgesehen sein, dass die in dem Aufnahmemodul ausgegebenen Refokussierungspulse auf ein breiteres Schichtprofil wirken als die insbesondere beschränkt auf eine aufzunehmende Schicht wirkenden Refokussierungspulse des Präparationsmoduls. Bezüglich dieser Ausgestaltung wurde erkannt, dass für die Ausprägung der unerwünschten Signalkohärenzpfade Phase und Flipwinkel der Refokussierungspulse im Auslesemodul entscheidend sind. Jede Abweichung des Flipwinkels von 180 ° bei den Refokussierungspulsen im Aufnahmemodul kann zu stärkeren Interferenzartefakten führen. Der Einfluss unvermeidbarer Variationen entlang der Schichtnormalen (Schichtprofil) lässt sich gemäß der vorliegenden Erfindung dadurch vermeiden bzw. verringern, dass die gewünschte Schichtdicke mit entsprechend selektiven Refokussierungspulsen im Präparationsmodul eingestellt wird und weiterhin die Selektivität der Refokussierungspulse im Aufnahmemodul reduziert wird. Das effektiv breite Schichtprofil der Aufnahme-Refokussierungspulse führt dazu, dass in dem für die Bildgebung relevanten Bereich der durch die Refokussierungspulse des Präparationsmoduls eingestellt wurde, der relevante Flipwinkel relativ konstant bleibt. Der Einfluss abfallender Flipwinkel im Randbereich des Schichtprofils für die Aufnahme-Refokussierungspulse wird so reduziert. Auf diese Weise kann eine weiter deutlich reduzierte Zahl und Stärke der Interferenzartefakte bei gleichzeitig homogener Bildhelligkeit erreicht werden.

Zweckmäßig ist es im Rahmen der vorliegenden Erfindung ferner, wenn die Gesamtheit der Präparationsgradientenpulse auch Maxwell-kompensiert gewählt wird. Auch sogenannte "begleitende Feldterme" (Maxwell-Terme) die beim Schalten von Gradientenfeldern auf Grund der Maxwell-Gleichungen auftreten, können zu (ortsabhängigen) Phasenänderungen führen und so zum Aufbau einer Nicht-MG-Signalkomponente beitragen. Durch Verwendung von gleichzeitig fluss- und maxwellkompensierten Präparationsgradientenpulsabfolgen lässt sich dieser Effekt reduzieren und die Bildqualität weiter verbessern. Fluss- und maxwellkompensierte Präparationsgradientenpulsabfolgen lassen sich sowohl bei einem als auch bei mehreren Refokussierungspulsen im Präparationsmodul realisieren.

Neben dem Verfahren betrifft die vorliegende Erfindung auch eine Magnetresonanzeinrichtung, aufweisend eine zur Durchführung des erfindungsgemäßen Verfahrens ausgebildete Steuereinrichtung. Sämtliche Ausführungen bezüglich des erfindungsgemäßen Verfahrens lassen sich analog auf die erfindungsgemäße Magnetresonanzeinrichtung übertragen, mit welcher mithin ebenso die bereits genannten Vorteile erhalten werden können. Die Steuereinrichtung kann wenigstens einen Prozessor und wenigstens ein Speichermittel aufweisen. Zweckmäßigerweise kann als Teil der Steuereinrichtung neben einer den Aufnahmebetrieb mit der Spinechosequenz steuernden Sequenzeinheit auch eine Kompensationseinheit zur Ermittlung geeigneter flusskompensierter Präparationsgradientenpulse vorgesehen sein.

Ein erfindungsgemäßes Computerprogramm ist beispielsweise direkt in einen Speicher einer Steuereinrichtung einer Magnetresonanzeinrichtung ladbar und weist Programmmittel auf, um die Schritte eines erfindungsgemäßen Verfahrens auszuführen, wenn das Computerprogramm in der Steuereinrichtung der Magnetresonanzeinrichtung ausgeführt wird. Das Computerprogramm kann auf einem erfindungsgemäßen elektronisch lesbaren Datenträger gespeichert sein, welcher mithin darauf gespeicherte elektronisch lesbare Steuerinformationen umfasst, welche zumindest ein genanntes Computerprogramm umfassen und derart ausgestaltet sind, dass sie bei Verwendung des Datenträgers in einer Steuereinrichtung einer Magnetresonanzeinrichtung ein erfindungsgemäßes Verfahren durchführen. Bei dem Datenträger kann es sich um einen nichttransienten Datenträger, beispielsweise eine CD-ROM, handeln.

Weitere Vorteile und Einzelheiten der vorliegenden Erfindung ergeben sich aus den im Folgenden beschriebenen Ausführungsbeispielen sowie anhand der Zeichnungen. Dabei zeigen:
- Fig. 1: eine mehrfach refokussierte Spinechosequenz gemäß dem Stand der Technik,
- Fig. 2: eine Prinzipskizze zur Anregung und der entstehenden transversalen Magnetisierung im rotierenden Koordinatensystem,
- Fig. 3 - 5: zum Zeitpunkt des ersten Refokussierungspulses gemäß Fig. 1 bei unterschiedlichen Bewegungen und Diffusionsarten vorliegende Magnetisierungsverteilungen,
- Fig. 6: ein erstes Ausführungsbeispiel einer erfindungsgemäßen mehrfach refokussierten Spinechosequenz,
- Fig. 7 - 9: Magnetisierungsverteilungen im rotierenden Koordinatensystem für die Diffusionszustände und Bewegungen der Figuren 3-5 bei Verwendung der Spinechosequenz gemäß Fig. 6,
- Fig. 10: ein zweites Ausführungsbeispiel einer erfindungsgemäßen mehrfach refokussierten Spinechosequenz, und
- Fig. 11: eine erfindungsgemäße Magnetresonanzeinrichtung.

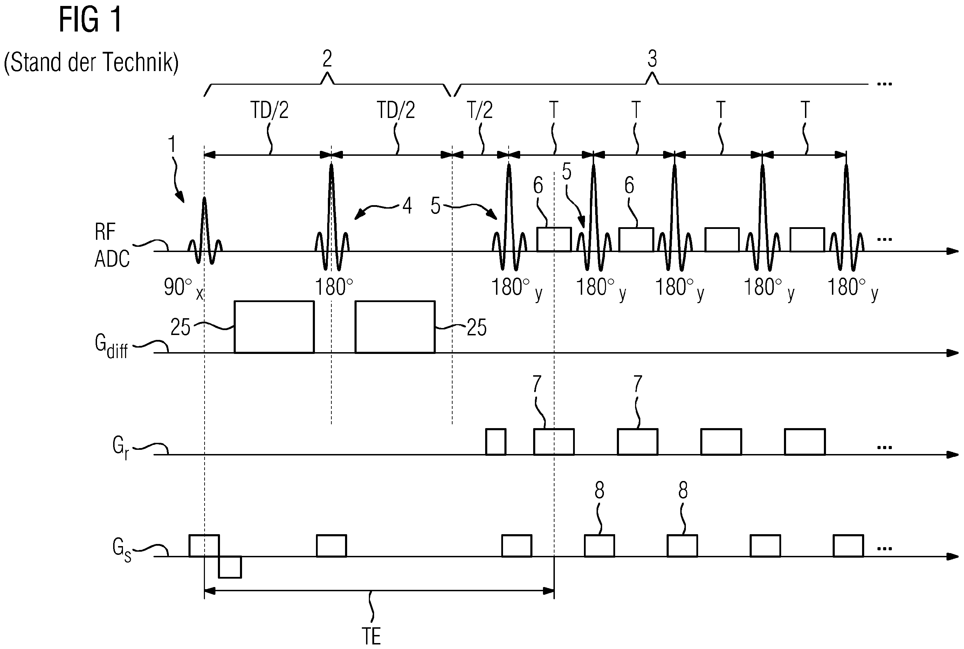

Fig. 1 zeigt ein Sequenzdiagramm einer mehrfach refokussierten Spinechosequenz zur Diffusionsbildgebung gemäß dem Stand der Technik. Dabei wird zunächst ein Hochfrequenz-Anregungspuls 1 ausgegeben, auf den ein Präparationsmodul 2 mit zwei Diffusionsgradientenpulsen 25, die zeitlich einen Refokussierungspuls 4 einschließen, folgt. In einem Aufnahmemodul 25 folgt auf Refokussierungspulse 5 jeweils zur Zeit des Spinechos ein Auslesezeitraum 6, in dem ein Auslesegradientenpuls 7 (Gᵣ) geschaltet ist. Auch entsprechend verwendete Schichtselektionspulse (Gₛ) 8 sind gezeigt.

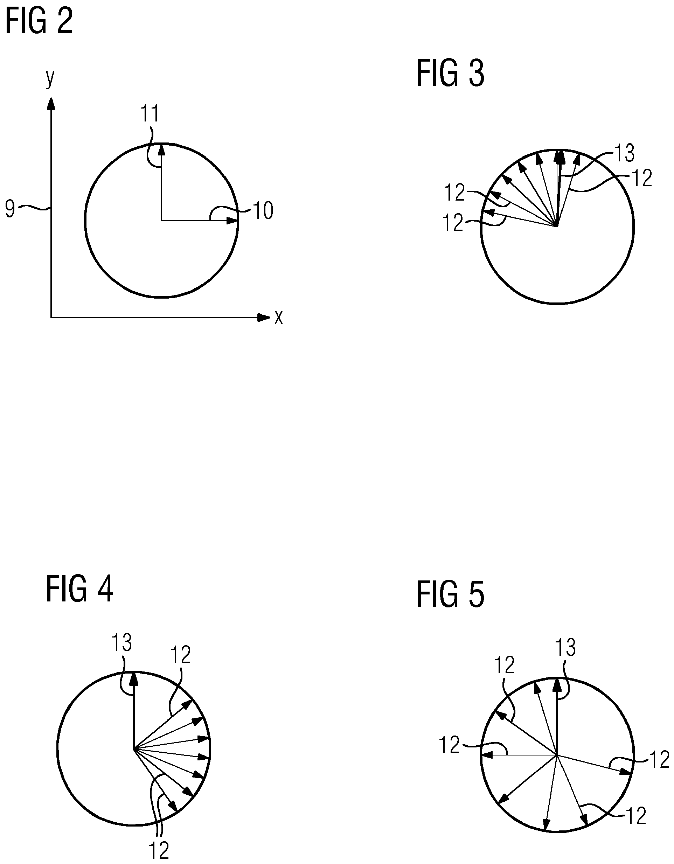

Fig. 2 erläutert die Wirkung des Anregungspulses 1 im auch in den weiteren entsprechenden Figuren verwendeten rotierenden Koordinatensystem 9. Beispielhaft wird die Phase des Anregungspulses 1 vorliegend so gewählt, dass sie, wie der Pfeil 10 anzeigt, entlang der x-Achse liegt. Damit wird eine transversale Magnetisierung gemäß dem Pfeil 11 entlang der rotierenden y-Achse erzeugt.

Die Diffusionsgradientenpulse 25 sind in einer bestimmten Diffusionsgradientenrichtung für den hier gezeigten Aufnahmevorgang orientiert und führen bezüglich der inkohärenten, als Diffusion zu vermessenden Bewegung dazu, dass sich die Phasen der transversalen Magnetisierung sozusagen gemäß der Stärke der Diffusion auffächern. Jedoch hat auch eine gegebenenfalls stattfindende kohärente Bewegung eine Auswirkung, nämlich eine gleichmäßige Gesamtverschiebung der Phasen der in einem Bildelement enthaltenen Spins.

Dies wird durch die Figuren 3 bis 5 näher erläutert. Die Fig. 3 betrifft eine eher langsamere Diffusion, mithin eine geringe Auffächerung, für eine erste kohärente Bewegung, wobei die Pfeile 12 die entsprechend bezüglich der Phase aufgefächerten Anteile der Transversalmagnetisierung zeigen.

Fig. 4 zeigt einen vergleichbaren Zustand zum Zeitpunkt T/2 vor der Anwendung eines ersten Refokussierungspulses 5, diesmal für eine andere kohärente Bewegung.

Fig. 5 betrifft eine dritte kohärente Bewegung und eine stärkere Diffusion, mithin eine breitere Auffächerung der Transversalmagnetisierung bezüglich der Phase.

Der jeweils ebenso gezeigte Pfeil 13 in den Figuren 3 bis 5 illustriert die Richtung des Refokussierungspulses 5, die gemäß dem CPMG-Schema im Beispiel entlang der y-Richtung gezeigt ist, da dort ohne die kohärente Bewegung der Schwerpunkt der Phasen, mithin der Mittelpunkt des Fächers, liegen sollte. Das bedeutet, auf Grund der unterschiedlichen Bewegungen erfüllen die Transversalmagnetisierungen die CPMG-Phasenbedingung nicht korrekt, welche jedoch eine Voraussetzung für eine hinreichende Reduzierung von Interferenzartefakten auf Grund unerwünschter Signalkohärenzpfade ist.

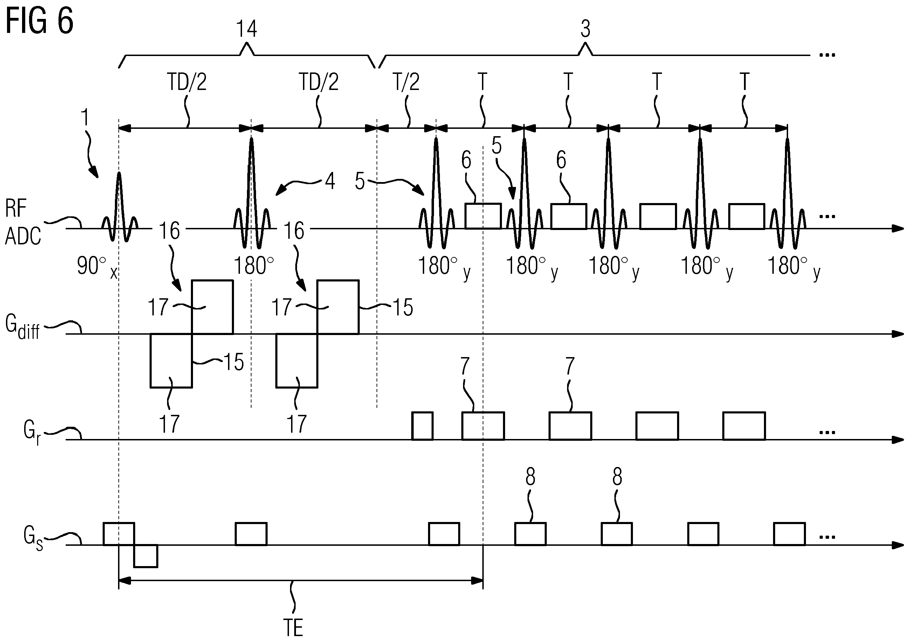

Fig. 6 zeigt ein erstes Ausführungsbeispiel einer erfindungsgemäßen mehrfach refokussierten Spinechosequenz, wie sie in einem ersten Ausführungsbeispiel des erfindungsgemäßen Verfahrens eingesetzt wird. Diese zeichnet sich durch ein modifiziertes Präparationsmodul 14 aus.

Zwar werden darin wiederum als Präparationsgradientenpulse 16 zwei Diffusionsgradientenpulse 15 verwendet, welche vor und nach dem Refokussierungspuls 4 jedoch jeweils zwei gleich lange, entgegengesetzte Teilpulse 17 aufweisen, die dazu führen, dass neben dem nullten Moment der Präparationsgradientenpulsfolge auch das erste Moment der Präparationsgradientenpulsfolge verschwindet. Das bedeutet, die Präparationsgradientenpulsfolge der Präparationsgradientenpulse 16 ist flusskompensiert. Zudem ist sie aufgrund der identischen Abfolge von Diffusionsgradienten vor und nach dem Refokussierungspuls 4 aber auch maxwellkompensiert.

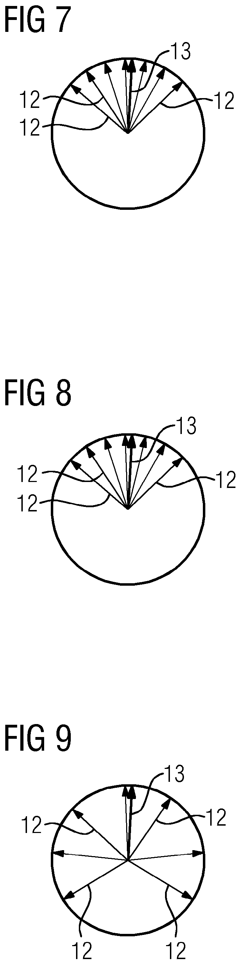

Während die Maxwell-Kompensation eine Reduzierung bezüglich auf Grund von Maxwell-Termen auftretenden Phasenänderungen mit sich bringt, führt die Flusskompensation dazu, dass die CPMG-Phasenbedingung auch bei Vorliegen kohärenter Bewegungen für den auf Grund der Diffusion entstehenden Fächer wieder erfüllt ist, wie die Figuren 7 bis 9 zeigen, die für dieselben Diffusionszustände/Bewegungen wie die Figuren 3 bis 5 das Phasenverhalten der transversalen Magnetisierung im rotierenden Koordinatensystem bei Verwendung des Präparationsmoduls 14 zeigen. Ersichtlich äußert sich die Diffusion wie gewünscht in einer Auffächerung und somit Reduzierung der Signalamplitude des um die CPMG-Phase zentrierten Fächers. Auf Grund der im Mittel erfüllten CPMG-Phasenbedingung werden die Interferenzartefakte wie bei Abwesenheit des Präparationsmoduls 14 kompensiert.

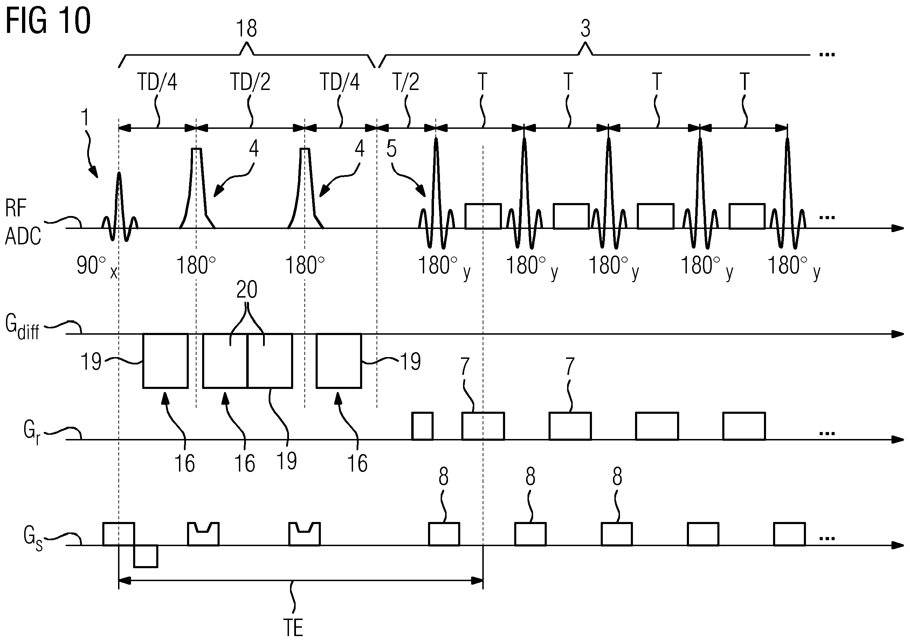

Fig. 10 zeigt das Sequenzdiagramm einer mehrfach refokussierten Spinechosequenz gemäß einem zweiten Ausführungsbeispiel des erfindungsgemäßen Verfahrens. In dem dort verwendeten Präparationsmodul 18 werden im Unterschied zu Fig. 6 zwei Refokussierungspulse 4 verwendet, die als adiabatische, identische FOCI-Pulse realisiert sind. Entsprechend liegen drei Präparationsgradientenpulse 16 als Diffusionsgradientenpulse 19 vor, wobei sich der mittlere Diffusionsgradientenpuls 19 wiederum gedanklich in Teilpulse 20 zerlegen lässt, die jeweils dem vorangehenden oder folgenden Diffusionsgradientenpuls 19 zugeordnet sind. Daraus ergibt sich, dass auch dort eine sowohl flusskompensierte als auch Maxwell-kompensierte Präparationsgradientenpulsabfolge vorliegt. Durch die Verwendung der adiabatischen Refokussierungspulse 4 können zusätzlich Bildinhomogenitäten auf Grund von räumlichen B1-Variationen kompensiert werden.

Es sei an dieser Stelle noch angemerkt, dass bei beiden Ausführungsbeispielen auch weitere qualitätsverbessernde Maßnahmen vorgesehen sein können. Beispielsweise können durch den Anregungspuls 1 und die Refokussierungspulse 4 erzeugte unerwünschte Signalkohärenzpfade durch Dephasierungsgradienten, wie beispielsweise in DE 10 2014 206 929 A1 beschrieben, unterdrückt werden. Ferner ist in beiden Ausführungsbeispielen die Ausgestaltung so gewählt, dass durch die Refokussierungspulse 4 in dem jeweiligen Präparationsmodul 14, 18 die gewünschte Schichtdicke auf Grund deren Selektivität eingestellt wird, die Selektivität der Refokussierungspulse 5 im Aufnahmemodul 3 jedoch reduziert ist (breiteres Schichtprofil). So bleibt im durch die Refokussierungspulse 4 selektierten Bereich der relevante Flipwinkel der Refokussierungspulse 5 (180 °) relativ konstant und der Einfluss abfallender Flipwinkel im Randbereich des Schichtprofils entlang der Schichtnormalen wird reduziert.

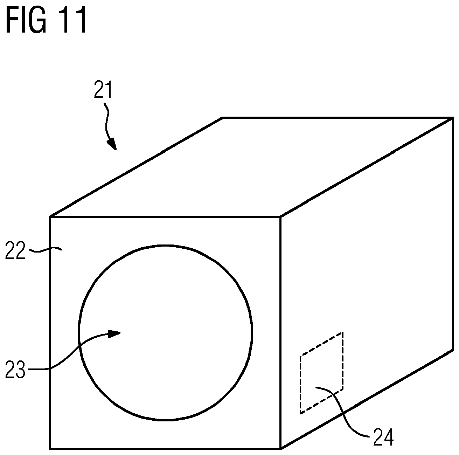

Fig. 11 zeigt schließlich eine Prinzipskizze einer erfindungsgemäßen Magnetresonanzeinrichtung 21. Diese weist, wie grundsätzlich bekannt, eine Hauptmagneteinheit 22 auf, in der eine Patientenaufnahme 23 ausgebildet ist, in die ein Patient über eine hier nicht näher gezeigte Patientenliege eingefahren werden kann. Die Patientenaufnahme 23 umgebend können eine Gradientenspulenanordnung und eine Hochfrequenzspulenanordnung angeordnet sein (hier nicht näher gezeigt). Der Betrieb der Magnetresonanzeinrichtung 21 wird durch eine Steuereinrichtung 24 gesteuert, die auch zur Ausführung des erfindungsgemäßen Verfahrens ausgebildet ist, insbesondere also zum Ausspielen der gezeigten mehrfach refokussierten Spinechosequenzen mit dem Präparationsmodulen 14, 18.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zur Aufnahme von Magnetresonanzdaten mit einer Magnetresonanzeinrichtung (21), wobei zur Einzelschussaufnahme der Magnetresonanzdaten eine mehrfach refokussierte Spinechosequenz verwendet wird, in der in einem Präparationsmodul (14, 18) anschließend an einen Anregungspuls (1) wenigstens zwei Präparationsgradientenpulse (16) und wenigstens ein Refokussierungspuls (4) ausgegeben werden und an das Präparationsmodul (14, 18) anschließend in einem Aufnahmemodul (3) mehrere Folgen eines Refokussierungspulses (5) und eines Auslesezeitraums (6) verwendet werden, **dadurch gekennzeichnet, dass** in ihrer Gesamtheit flusskompensierte Präparationsgradientenpulse (16) verwendet werden.

2. Verfahren nach Anspruch 1, **dadurch gekennzeichnet, dass** die Präparationsgradientenpulse (16) zudem wenigstens ein höheres Moment minimierend gewählt werden.

3. Verfahren nach Anspruch 1 oder 2, **dadurch gekennzeichnet, dass** als Spinechosequenz eine HASTE-Sequenz verwendet wird.

4. Verfahren nach einem der vorangehenden Ansprüche, **dadurch gekennzeichnet, dass** in dem Präparationsmodul (18) zwei adiabatische, insbesondere identische Refokussierungspulse (4) verwendet werden, die zeitlich jeweils zwischen Präparationsgradientenpulsen (16) liegen.

5. Verfahren nach einem der vorangehenden Ansprüche, **dadurch gekennzeichnet, dass** zur Unterdrückung von insbesondere durch den Anregungspuls (1) und die Refokussierungspulse (4) des Präparationsmoduls (14, 18) erzeugten, unerwünschten Signalkohärenzpfaden gegenüber den erwünschten Signalkohärenzpfaden Dephasierungsgradienten verwendet werden.

6. Verfahren nach einem der vorangehenden Ansprüche, **dadurch gekennzeichnet, dass** die in dem Aufnahmemodul (3) ausgegebenen Refokussierungspulse (5) auf ein breiteres Schichtprofil wirken als die insbesondere beschränkt auf eine aufzunehmende Schicht wirkenden Refokussierungspulse (4) des Präparationsmoduls (14, 18).

7. Verfahren nach einem der vorangehenden Ansprüche, **dadurch gekennzeichnet, dass** die Gesamtheit der Präparationsgradientenpulse (16) auch Maxwell-kompensiert gewählt wird.

8. Magnetresonanzeinrichtung (21), aufweisend eine zur Durchführung eines Verfahrens nach einem der vorangehenden Ansprüche ausgebildete Steuereinrichtung (24).

9. Computerprogramm, welches die Schritte eines Verfahrens nach einem der Ansprüche 1 bis 7 durchführt, wenn es auf einer Steuereinrichtung (24) einer Magnetresonanzeinrichtung (21) ausgeführt wird.

10. Elektronisch lesbarer Datenträger, auf dem ein Computerprogramm nach Anspruch 9 gespeichert ist.
